(19) Europäisches Patentamt
European Patent Office
Office européen des brevets

(11) Veröffentlichungsnummer: **0 231 002 B1**

(12) **EUROPÄISCHE PATENTSCHRIFT**

(45) Veröffentlichungstag der Patentschrift: **12.08.92**

(51) Int. Cl.$^5$: **C08F 8/14**, C08F 8/30, C08F 8/34, C08F 299/00

(21) Anmeldenummer: **87100994.0**

(22) Anmeldetag: **24.01.87**

(54) **Vernetzbare feste Kautschukelastische Polymerisate.**

(30) Priorität: **28.01.86 DE 3602472**

(43) Veröffentlichungstag der Anmeldung:
**05.08.87 Patentblatt 87/32**

(45) Bekanntmachung des Hinweises auf die Patenterteilung:
**12.08.92 Patentblatt 92/33**

(84) Benannte Vertragsstaaten:
**AT CH DE ES FR GB IT LI NL SE**

(56) Entgegenhaltungen:
**FR-A- 2 123 284**
**FR-A- 2 125 958**
**US-A- 4 216 302**

(73) Patentinhaber: **BASF Aktiengesellschaft**
**Carl-Bosch-Strasse 38**
**W-6700 Ludwigshafen(DE)**

(72) Erfinder: **Koch, Horst, Dr.**
**Schliffgasse 22**
**W-6711 Grosskarlbach(DE)**
Erfinder: **Ziegler, Walter, Dr.**
**Starenweg 15**
**W-6803 Edingen-Neckarhausen(DE)**

**EP 0 231 002 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft vernetzbare feste kautschukelastische Polymerisate in Säureform oder in Form ihrer Salze, erhältlich durch polymeranaloge Umsetzung von

A) einem Copolymerisat aus

$a_1$) 30 bis 70 Gew.-Teilen Ethylen,

$a_2$) 5 bis 40 Gew.-Teilen Acrylsäure und/oder Methacrylsäure und

$a_3$) 5 bis 50 Gew.-Teilen eines oder mehrerer Vinylester, Vinylether, Acrylsäureester, Methacrylsäureester, Acrylsäureamide und/oder Methacrylsäureamide

mit

B) Verbindungen, durch welche seitenständige Reste der allgemeinen Formel I,

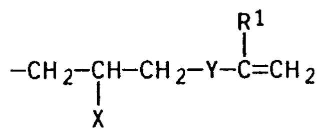 I

in denen

X eine Hydroxi-, eine Amino- oder eine Mercapto-Gruppe,

Y eine Ester-, eine Amid-, eine Ether- oder eine $C_1$- bis $C_{10}$-Alkylen-Gruppe und

$R^1$ ein Wasserstoffatom oder eine Methylgruppe bedeuten,

und

C) gegebenenfalls weitere seitenständige Reste der allgemeinen Formel II,

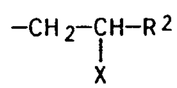 II

in denen

$R^2$ eine polare Gruppe, ein Wasserstoffatom oder eine weitere Gruppe X bedeutet, in das Copolymerisat A eingeführt werden.

Die Erfindung betrifft außerdem die Verwendung dieser Polymerisate zur Herstellung von durch Photopolymerisation vernetzbaren Massen, von Druckplatten, Reliefplatten und Photoresists sowie von photovernetzten Druckformen, Reliefformen und Photoresists, hergestellt durch Verwendung solcher Polymerisate.

Polymerisate ähnlicher Art sind aus JP-A-76/144 445 und JP-A-75/073 944 bekannt. Diese Patentveröffentlichungen beschreiben Umsetzungsprodukte flüssiger Butadien-Kautschuke mit Molgewichten von 500 bis 3000 mit a) Maleinsäureanhydrid in der ersten Stufe und b) mit Acrylsäureestern, welche Hydroxyl- oder Glycidylgruppen in ihren Alkylresten enthalten, in der zweiten Stufe. Sie stellen demnach Butadienkautschuke mit seitenständigen photopolymerisierbaren Gruppen B und seitenständigen Carboxylgruppen dar und werden zur Herstellung von Druckplatten und Druckformen verwendet. Derartige Polymerisate zeigen jedoch anwendungstechnische Nachteile: Wegen ihrer niederen Molgewichte sind sie flüssig oder pastös und daher schlecht handhabbar. Photovernetzbare Massen und Druckplatten auf dieser Basis sind nicht dimensionsstabil und kaum lagerfähig. Photovernetzbare Massen, Druckformen, Reliefformen und Photoresists, hergestellt unter Verwendung derartiger Polymerisate, sind klebrig, thermolabil und nicht rißbeständig.

Aus der FR-A 2 123 284 sind Polymersysteme mit seitenständigen photopolymerisierbaren Resten auf der Basis von Copolymerisaten aus Styrol/Acrylsäure, Styrol/Acrylsäure/Acrylnitril und Styrol/Acrylsäure/n-Butylacrylat bekannt. Sie werden durch Umsetzung der Carboxylgruppen tragenden Copolymerisate mit Acrylsäureestern, die Glycidylgruppen in ihren Alkylresten enthalten, gewonnen. Derartige Polymerisate werden in Form eines Gemisches mit ethylenisch ungesättigten Verbindungen als photopolymerisierbare Massen für die Herstellung von Reliefs und Flachdruckformen verwendet.

Der vorliegenden Erfindung lag die Aufgabe zugrunde, die bekannten vernetzbaren Polymerisate durch neue feste, kautschukelastische und in üblichen Lösungsmitteln lösliche Polymerisate zu ersetzen, welche es im weiteren ermöglichen, dimensionsstabile, lagerfähige, durch Photopolymerisation vernetzbare Massen, Druckplatten, Reliefplatten und Photoresists sowie thermostabile, rißbeständige und nicht klebrige

photovernetzte Massen, Druckformen, Reliefformen und Photoresists herzustellen.

Demgemäß wurden die eingangs definierten Polymerisate gefunden, die im folgenden als "erfindungsgemäße Polymerisate" bezeichnet werden.

Die erfindungsgemäßen Polymerisate sind vernetzbar, fest und kautschukelastisch und zeichnen sich durch ihre vorzügliche Löslichkeit in üblichen Lösungsmitteln, insbesondere aber in Wasser, aus. Sie können nach der Zugabe geeigneter Zusatzstoffe durch Photopolymerisation vernetzt werden. Dabei zeichnen sie sich durch eine gute Verträglichkeit mit zahlreichen Zusätzen aus. Die durch Photopolymerisation vernetzbaren Massen, Druckplatten, Reliefplatten und Photoresists auf der Basis der erfindungsgemäßen Polymerisate sind kautschukelastisch, dimensionsstabil und lagerfähig. Photovernetzte Druckformen, Reliefformen, Photoresists und Massen auf dieser Grundlage sind thermostabil, rißbeständig und nicht klebrig.

Im Rahmen der vorliegenden Erfindung werden Stoffe dann als "verträglich" bezeichnet, wenn sie in der Lage sind, ineinander dispergiert zu bleiben. Der Begriff "Massen" bezeichnet Materialien mit beliebiger äußerer Form, z.B. Klebmassen, Dichtungsmassen oder Folien ohne einen Gehalt an bildmäßiger Information, wohingegen unter dem Begriff "Formen" Materialien verstanden werden, die sich durch einen bildmäßigen Informationsgehalt auszeichnen, z.B. Druckformen, Reliefformen und Photoresists.

Copolymerisate A aus

$a_1$) Ethylen,

$a_2$) (Meth)Acrylsäure und

$a_3$) mindestens einem Vinylester, Vinylether, (Meth)Acrylsäureester und/oder (Meth)Acrylsäureamid sind an sich bekannt.

Ihre Darstellung kann z.B. nach der LDPE (= low density polyethylene)Hochdruckpolymerisations-Methode bei Temperaturen von 200 bis 400 °C und einem Druck von mehr als 800 kg/cm$^2$ erfolgen [siehe z.B. DE-PS 23 41 462, US-PS 3 264 272 und die europäische Patentanmeldung EP-A 224 029].

Als Comonomere $a_3$ geeignete Vinylester sind insbesondere solche der allgemeinen Formel III

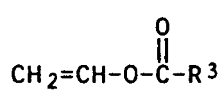

III

worin $R^3$ einen Alkyl- oder Cycloalkylrest mit 1 bis 10 C-Atomen bedeutet, z.B. Vinylacetat, Vinylpropionat, Vinylbutyrat, Valeriansäurevinylester oder Hexancarbonsäurevinylester. Bevorzugt ist Vinylacetat.

Als Comonomere $a_3$ geeeignete Vinylether sind insbesondere solche der allgemeinen Formel IV,

$CH_2 = CH\text{-}OR^3$ IV

z.B. Vinylethylether, Vinyl-1-propylether, Vinyl-2-propylether, Vinyl-1-butylether, Vinyl-2-butylether oder Vinyl-1-pentylether. Bevorzugt ist Vinyl-1-butylether.

Als Comonomere $a_3$ geeignete (Meth)Acrylsäureester und -amide sind insbesondere solche der allgemeinen Formel V

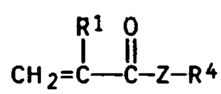

V

worin $R^1$ die zu Formel I angegebene Bedeutung besitzt, $R^4$ einen Alkyl-oder Cycloalkylrest mit 1 bis 10 C-Atomen oder einen ω-Methyl-poly(alkylenoxid)-α-yl-Rest darstellt und Z ein Sauerstoffatom oder eine $NR^5$-Gruppe mit $R^5$ = H oder $C_1$-$C_4$-Alkyl bezeichnet. Beispiele geeigneter (Meth)Acrylsäureester und/oder -amide sind Methylacrylat, Methylmethacrylat, Ethylacrylat, Ethylmethacrylat, Propylacrylat, Propylmethacrylat, n-Butylacrylat, n-Butylmethacrylat, n-Pentylacrylat, n-Pentylmethacrylat, n-Hexylacrylat, n-Hexylmethacrylat, t-Butylacrylat, Cyclohexylacrylat, Cyclohexylmethacrylat, 2-Ethylhexylacrylat, 2-Ethylhexylmethacrylat, Dicyclopentadienylacrylat, ω-Methyl-poly(ethylenoxid)-α-yl-(meth)acrylat, ω-Methyl-poly(propylen-1,2-oxid)-α-yl-(meth)acrylat, ω-Methyl-poly(propylen-1,3-oxid)-α-yl-(meth)acrylat, N-Ethylacrylamid, N-Methyl-N-butylmethacrylamid, N-Ethyl-N-(2-ethylhexyl)-acrylamid u.a. Bevorzugt sind n-Butylacrylat, 2-Ethylhexylacrylat, ω-Methyl-poly(ethylenoxid)-α-yl-acrylat und Dicyclopentadienylacrylat, von denen die ersten drei besonders bevorzugt sind.

Bevorzugte Copolymerisate A sind Ethylen-(Meth)Acrylsäure-Copolymerisate, die n-Butylacrylat, 2-Ethylhexylacrylat und/oder ω-Methyl-poly(ethylenoxid)-α-yl-acrylat als Comonomere $a_3$ einpolymerisiert enthalten. Vorteilhafte Copolymerisate A' haben eine Shore A-Härte von über 10 und insbesondere von 15 bis 75.

Beispiele geeigneter seitenständiger olefinisch ungesättigter Reste B sind die 2-Hydroxi-5-oxo-4-oxahept-6-en-1-yl-, 2-Amino-5-oxo-4-oxahept-6-en-1-yl-, 2-Mercapto-5-oxo-4-oxahept-6-en-1-yl-, 2-Hydroxi-5-oxo-4-oxa-6-methylhept-6-en-1-yl-, 2-Amino-5-oxo-4-oxa-6-methylhept-6-en-1-yl-, 2-Mercapto-5-oxo-4-oxa-6-methylhept-6-en-1-yl-, 2-Hydroxi-5-oxo-4-azahept-6-en-1-yl-, 2-Amino-5-oxo-4-azahept-6-en-1-yl-, 2-Mercapto-5-oxo-5-azahept-6-en-1-yl-, 2-Hydroxi-5-oxo-4-aza-6-methylhept-6-en-1-yl-, 2-Amino-5-oxo-4-aza-6-methylhept-6-en-1-yl-, 2-Mercapto-5-oxo-4-aza-6-methylhept-6-en-1-yl-, 2-Hydroxi-4-oxahex-5-en-1-yl-, 2-Amino-4-oxahex-5-en-1-yl-, 2-Mercapto-4-oxahex-5-en-1-yl-, 2-Hydroxi-hex-5-en-1-yl-,2-Amino-hex-5-en-1-yl-, 2-Mercapto-hex-5-en-1-yl-, 2-Hydroxi-hept-6-en-1-yl-, 2-Amino-hept-6-en-1-yl- oder 2-Mercapto-hept-6-en-1-yl-Reste. Bevorzugt ist der 2-Hydroxy-5-oxo-4-oxa-6-methyl-hept-6-en-1-yl-Rest VI

$$-CH_2-\underset{OH}{\underset{|}{CH}}-CH_2-O-\underset{O}{\underset{\|}{C}}-\underset{CH_3}{\underset{|}{C}}=CH_2 \qquad VI.$$

Die erfindungsgemäßen Polymerisate können außer den oben angegebenen Resten B zusätzlich seitenständige Reste C enthalten, welche polare Gruppen, die zur Dipol-Dipol-, Dipol-Ion- oder Ion-Ion-Wechselwirkung befähigt sind, aufweisen. Geeignete Reste c sind z.B. 2-Hydroxi-eth-1-yl-, 2-Amino-eth-1-yl-, 2-Mercapto-eth-1-yl-, 2,3-Dihydroxi-prop-1-yl-, 2-Amino-3-hydroxy-prop-1-yl-, 2-Mercapto-3-hydroxy-prop-1-yl- oder ω-Alkylpoly(ethylenoxid)-α-oxyl-Reste.

In einer bevorzugten Verfahrensweise erfolgt die Einführung der seitenständigen olefinisch ungesättigten Reste B und auch gegebenenfalls der Reste C in die Copolymerisate A - d.h. die Synthese der erfindungsgemäßen Polymerisate - durch partielle oder vollständige Umsetzung der Carboxylgruppen in den Copolymerisaten A mit geeigneten Oxiran-2-yl-, Thiiran-2-yl- und Aziridin-2-yl-Verbindungen, wobei man die Mengen so wählt, daß mindestens eine Carboxylgruppe umgesetzt wird. Wünscht man, zusätzlich zu den olefinisch ungesättigten Resten B, noch Reste C einzuführen, dann werden zur Einführung der Reste B die Carboxylgruppen nur partiell umgesetzt, so daß pro Molekülkette mindestens noch eine Carboxylgruppe für die Einführung des Restes C zur Verfügung steht. Um in den Endprodukte noch freie Carboxylgruppen für eine gegebenenfalls erfolgende Salzbildung zur Verfügung zu haben, ist es vorteilhaft, insgesamt nur einen Teil der Carboxylgruppen bei der Einführung der Reste B und gegebenenfalls C reagieren zu lassen.

Die Umsetzung von Carboxylgruppen enthaltenden Verbindungen mit Oxiran-2-yl-, Thiiran-2-yl- oder Aziridin-2-yl-Verbindungen unter Ringöffnung und Bildung eines α-Hydroxy-, α-Mercapto- und α-Amino-Esters ist an sich bekannt und wird beispielsweise in der Firmenschrift "Reactive Monomers", Nissan Blemmer G, High Polymer Modifiers (Nippon Oil and Fats, Co. Ltd.) aus dem Jahr 1968 beschrieben. Ferner ist es bekannt, daß anstelle von Oxiran-2-yl-Verbindungen auch Glycidyl-Verbindungen eingesetzt werden können. In einer bevorzugten Verfahrensweise setzt man die Copolymerisate A mit diesen Verbindungen um in Lösungsmitteln wie Tetrahydrofuran, Toluol, Ethylbenzol, Methylethylketon, Methylisobutylketon oder Gemischen aus denselben. Zu den Lösungen der Copolymerisate A fügt man gegebenenfalls p-Dimethylaminopyridin oder N-Methylimidazol als Katalysator und z.B. 2,6-Di-tert.-butyl-p-kresol oder N-Nitrosodiphenylamin als Inhibitor zu. Zu diesen Lösungen tropft man die gewünschte Menge an Oxiran-2-yl-bzw. Glycidyl-, Thiiran-2-yl- oder Aziridin-2-yl-Verbindung mit einer solchen Geschwindigkeit, daß die Temperatur des Reaktionsgemisches bei 40 bis 110 °C liegt. Gegebenenfalls wird die Temperatur durch Heizen oder Kühlen eingestellt. Nach dem Zutropfen wird die Reaktionsmischung mit Vorteil 3 bis 10 Stunden lang bei 50 °C nachgerührt und das Lösungsmittel in geeigneter Weise, beispielsweise durch Vakuumdestillation entfernt. In einer weiteren vorteilhaften Verfahrensweise setzt man das Copolymerisat A zusammen mit den vorstehend genannten Verbindungen auf einem Kneter um, z.B. bei 125 bis 180 °C während 3 bis 60 Minuten, oder führt die Reaktion in einem Zweischneckenextruder durch, mit Vorteil mit einer Verweilzeit von 5 bis 10 Minuten.

Geeignete Verbindungen für die nachgenannte Umsetzung zur Einführung der Reste B sind z.B. Oxiran-2-methylolacrylat, Oxiran-2-methylolmethacrylat, Glycidylacrylat, Glycidylmethacrylat, Aziridin-2-methylolacrylat, Aziridin-2-methylolmethacrylat, Thiiran-2-methylolacrylat oder Thiiran-2-methylolmethacrylat; N-(2-Oxiranyl)methylacrylamid, N-(2-Oxiranyl)methylmethacrylamid, N-(2,3-Dihydroxy-1-propyl)acrylamid, N-(2,3-Dihydroxy-1-propyl)methacrylamid, N-(2-Aziridinyl)methylacrylamid, N-(2-Aziridinyl)-methylmethacrylamid,

N-(2-Thiiranyl)methylacrylamid oder N-(2-Thiiranyl)-methylmethacrylamid; 1-(Oxiran-2-yl)-2-oxabuten-3, Glycidylmonovinylether, 1-(Aziridin-2-yl)-2-oxabuten-3 oder 1-(Thiiran-2-yl)-2-oxabuten-3; 4-(Oxiran-2-yl)-buten-1, 5,6-Dihydroxyhexen-1, 5-(Oxiranyl-2-yl)-penten-1,6,7-Dihydroxypenten-1, 4-(Aziridin-2-yl)-buten-1, 5-(Aziridin-2-yl)-penten-1, 4-(Thiiran-2-yl)-buten-1 oder 5-(Thiiran-2-yl)-penten-1. Bevorzugt sind Glycidylmethacrylat und Oxiran-2-methylolmethacrylat. Sie werden in der Regel in Mengen von 1 bis 30, vorzugsweise 2 bis 20 und insbesondere 3 bis 15 Gew.%, bezogen auf das Polymerisat angewendet.

Für die Umsetzung zur fakultativen Einführung von Resten C sind z.B. geeignet Oxiran, Aziridin, Thiiran, 2-Methyloloxiran, 2-Methylolaziridin, 2-Methylolthiiran oder 2-[ω-Methyl-poly(ethylenoxid)]-oxiran, ferner Verbindungen, welche Glycidyl-, Oxiranyl-, Aziridinyl- oder Thiiranyl-Reste und stark polare Gruppen enthalten.

Die erfindungsgemäßen Polymerisate werden mit Vorteil für die Herstellung von durch Photopolymerisation vernetzbaren Massen, Druckplatten, Reliefplatten und Photoresists verwendet. Dazu werden ihnen geeignete Photoinitiatoren in wirksamen Mengen sowie gegebenenfalls geeignete photopolymerisierbare Monomere, Salzbildner, Weichmacher, Inhibitoren der thermisch initiierten Polymerisation, Farbstoffe und Pigmente, Mittel zur Verbesserung der Reliefstruktur, Vernetzungshilfsmittel, Antioxidantien, Füllstoffe, Flußmittel oder Formtrennmittel beigegeben. Mischungen aus den erfindungsgemäßen Polymerisaten und diesen geeigneten Zusatzstoffen werden im folgenden der Kürze halber als "Gemische" bezeichnet.

Geeignete Photoinitiatoren sind beispielsweise Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethyl-acetal; oder Acyldiarylphosphinoxide gemäß DE-OS 29 09 992; oder substituierte und unsubstituierte Chinone, wie Ethylanthrachinon, Benzanthrachinon, Benzophenon oder 4,4'-Bis(dimethylamino)benzophenon. Sie können allein oder im Gemisch miteinander oder in Verbindung mit Coinitiatoren verwendet werden, z.B. Ethylanthrachinon mit 4,4'-Bis(dimethylamino)benzophenon, Benzoinmethylether mit Triphenylphosphin, Diacylphosphinoxide mit tertiären Aminen oder Acyldiarylphosphinoxide mit Benzildimethylacetal. In den Gemischen werden sie in einer Menge von 0,001 bis 10, vorteilhaft 0,1 bis 5 und insbesondere 0,3 bis 2 Gew.%, bezogen auf ein Gemisch, verwendet, wobei die Menge mitbestimmt wird von der Mitverwendung photopolymerisierbarer Monomerer.

Geeignete photopolymerisierbare Monomere sind beispielsweise aus US-PS 2 760 863 oder US-PS 3 060 023 bekannt. Sie besitzen einen Siedepunkt von über 100 °C bei Atmosphärendruck und ein Molgewicht von bis zu 3000, insbesondere von bis zu 2000. Geeignet sind die Ester der Acrylsäure und/oder Methacrylsäure mit ein- oder mehrwertigen Alkoholen, z.B. Butylacrylat, Butylmethacrylat, 2-Ethylhexylacrylat, Lauryl(meth)acrylat, Ethlenglykol-di(meth)acrylat, Butandiol-1,4-di(meth)acrylat, Neopentylglykol-di-(meth)acrylat, 3-Methylpentandiol-di(meth)acrylat, 2-Hydroxipropyl(meth)acrylat, 2-Hydroxiethyl(meth)acrylat, 1,6-Hexandiol-di(meth)acrylat, 1,1,1-Trimethylolpropantri(meth)acrylat, Di-, Tri- und Tetraethylenglykoldi-(meth)acrylat, Tripropylenglykol-di(meth)acrylat oder Pentaerythrit-tetra(meth)acrylat, des weiteren Poly-(ethylenoxid)di(meth)acrylat, ω-Methylpoly(ethylenoxid)-α-yl-(meth)acrylat, N,N-Diethylaminoethylacrylat oder ein Umsetzungsprodukt aus 1 Mol Glycerin, 1 Mol Epichlorhydrin und 3 Mol Acrylsäure; die Vinylester aliphatischer Monocarbonsäuren, z.B. Vinyloleat; die Vinylether von Alkoholen, z.B. Octadecylvinylether und Butandiol-1,4-divinylether; die Diester von Fumar- und Maleinsäure; oder die Umsetzungsprodukte aus OH-terminierten, oligomeren Polybutadienen mit Maleinsäure oder (Meth)Acrylsäure, d.h. oligomere Polybutadiene mit aktivierten, photopolymerisierbaren olefinischn Doppelbindungen. In den Gemischen werden sie - einzeln oder als Mischung - in einer Menge von 1 bis 40, vorteilhafterweise 3 bis 30 und insbesondere 5 bis 20 Gew.%, bezogen auf ein Gemisch, verwendet.

Geeignete Salzbildner sind

1. anorganische Metallverbindungen wie Oxide, Hydroxide, Alkoxide mit 1 bis 4 C-Atomen im Alkylrest oder Carbonate der Kationen von Li, Mg, Ca, Sr, Ba, Al, Ga, In, Ge, Sn, Pb, Sb, Bi, Zn, Cd, Mg, Cn, Sc, Y, La, Ti, Zr, Hf, V, Nb, Ta, Cr, Mo, W, Mn, Re, Fe, Co, Ni, Pd oder den Lanthaniden oder

2. organische Metallverbindungen der Struktur (VII)

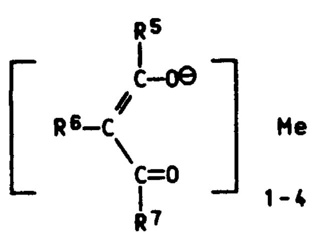

(VII),

worin Me ein Kation eines der vorstehend genannten Elemente bedeutet, $R^5$, $R^6$ und $R^7$ gleichartige

oder verschiedenartige Alkyl-, Cycloalkyl-, Aryl- oder Alkylarylgruppen darstellen, wobei die Reste $R^5$ und $R^7$ cyclisch über Ringsysteme miteinander verknüpft sein können und wobei ferner $R^6$ auch noch ein Wasserstoffatom kennzeichnen kann, oder

3. Ammoniak oder

4. mehrfachfunktionelle Amine wie Ethylendiamin, Diethylentriamin, N-Methyl-N-ethyl-ethylendiamin, N,N-Dimethyl-ethylendiamin, N,N′-Diethylethylen-diamin, N,N,N′,N′-Tetramethylethylendiamin, N,N,N".N"-Tetramethylethylentriamin, 1,3-Diaminopropan 1,4-Diaminobutan, Pyrazin oder Polyvinylpyridin oder

5. Hydrazin.

Bevorzugt sind die Oxide, Hydroxide, Alkoxide, Carbonate und Acetylacetonate von $Li^{\oplus}$, $Mg^{2\oplus}$, $Ca^{2\oplus}$, $Sr^{2\oplus}$, $Ba^{2\oplus}$, $Al^{3\oplus}$, $Sn^{2\oplus}$, $Sb^{3\oplus}$ und $Zn^{2\oplus}$, wobei Bis(acetylacetonato)-Zn(II), MgO und LiOH besonders bevorzugt sind.

Vorteilhafterweise werden sie in einer Menge von 0,05 bis 20, vorzugsweise 0,5 bis 15 und insbesondere 1 bis 10 Gew.%, bezogen auf ein erfindungsgemäßes Polymerisat, verwendet.

Geeignete Weichmacher sind z.B. modifizierte und unmodifizierte Naturöle und -harze wie paraffinische oder naphthenische Öle sowie Erdölharze oder Pentaerythritolester von hydriertem Kollophonium; Alkyl-, Alkenyl-, Arylalkyl- oder Arylalkenylalkoholester von Säuren wie Zitronensäure, Essigsäure, Propionsäure, Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze wie Oligostyrol, oligomere Styrol-Butadien-Copolymerisate, Oligo-α-methylstyrol, oligomere α-Methylstyrol-Vinyltoluol-Copolymerisate, flüssige 1,2- oder 1,4-Oligobutadiene, Oligopentadiene, flüssige oligomere Acrylnitril-Butadien-Copolymerisate sowie Polyterpen-, Polyacrylat-, Polyester- oder Polyurethanharze, synthetische Polymere wie Polyethylen oder Ethylen-Propylen-Dien-Kautschuke; ω-Methyl-oligo(ethylenoxid); oder Sulfonamide. Von Vorteil sind Mengen von 1 bis 20 Gew.%, bezogen auf ein Gemisch.

Geeignete Inhibitoren der thermisch initiierten Polymerisation, die im allgemeinen in einer Menge von 0,001 bis 2 Gew.%, bezogen auf ein Gemisch, zugesetzt werden und die keine nennenswerte Eigenabsorption in dem aktinischen Bereich, in dem der Photoinitiator absorbiert, aufweisen, sind z.B. Hydrochinon, p-Methoxiphenol, 2,6-Di-tert.-butyl-p-kresol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze, des N-Nitrosocyclohexylhydroxylamins.

Geeignete Farbstoffe, Pigmente oder photochrome Zusätze werden den Gemischen in einer Menge von 0,0001 bis 2 Gew.%, bezogen auf ein Gemisch, zugesetzt. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie - ebenso wenig wie die Inhibitoren der thermisch initiierten Polymerisation - die Photopolymerisation der Gemische stören. Geeignet sind z.B. die löslichen Phenazinium-, Phenoxazinium-, Acridinium und Phenothiaziniumfarbstoffe, wie Neutralrot (C.I. 50040), Safranin T (C.I. 50240), Rhodanilblau, dem Salz bzw. Amid aus Rhodamin D (Basic Violett 10), Rhodanilblau, dem Salz bzw. Amid aus Rhodamin D (Basic Violett 10, C.I. 45170), Methylenblau B (C.I. 52015), Thioninblau G (C.I. 52025), Thioninblau G (C.I. 52025) oder Acridinorange (C.I. 46005); sowie auch Solvent Black 3 (C.I. 26150). Diese Farbstoffe werden auch zusammen mit einer hinreichenden Menge eines Reduktionsmittels verwendet, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexyl-hydroxylamins, vorzugsweise die Kalium-, Calcium- und Aluminiumsalze. Letztere können, wie erwähnt, zugleich als Inhibitoren der thermisch initiierten Polymerisation dienen. Die Reduktionsmittel werden im allgemeinen in Mengen von 0,005 bis 5 Gew.%, bezogen auf ein Gemisch, zugesetzt, wobei sich in vielen Fällen der Zusatz eines 3- bis 10fachen der Menge an mitverwendetem Farbstoff bewährt hat.

Geeignete Mittel zur Verbesserung der Reliefstruktur der aus den Gemischen hergestellten Druckformen sind beispielsweise 9,9′-Dianthronyl und 10,10′-Bisanthron gemäß DE-OS 27 20 560.

Die Gemische können ferner Vernetzungshilfsmittel wie die in US-PS 4 179 531 und US-PS 4 234 676 beschriebenen tri- und tetrafunktionellen Mercaptoverbindungen enthalten.

Zum Schutz der Gemische vor oxidativem und thermooxidativem Abbau durch Luftsauerstoff können ihnen wirksame Mengen an geeigneten Antioxidantien zugesetzt werden, z.B. sterisch gehinderte Monophenole wie 2,6-Di-tert.-butyl-p-kresol; alkylierte Thiobis- und Alkylidenbisphenole wie 2,2′-Methylen-bis-(4-methyl-6-tert.-butylphenol) oder 2,2′-Bis-(1-hydroxi-4-methyxl-6-tert.-butylphenyl)sulfid; Hydroxibenzyle wie 1,3,5-Trimethyl-2,4,6-tris-(3,5-di-tert.-butyl-4-hydroxibenzyl)benzol; Triazine wie 2-(4-Hydroxi-3,5-tert.-butylanilino)-4,6-bis-(n-octylthio)-1,3,5-triazin; polymerisiertes Trimethyldihydrochinon; Zinkdibutyldithiocarbamat; Dilaurylthiodipropionat; oder Phosphite wie Tris(nonylphenyl)phosphit. Von Vorteil sind Mengen 0,001 bis 5 Gew.%, bezogen auf ein Gemisch.

Geeignete nicht mischbare polymere oder nicht polymere organische und anorganische Füllstoffe oder Verstärkungsfüllstoffe sind solche, die für die Wellenlängen des zur Belichtung der erfindungsgemäßen Gemische verwendeten Lichts im wesentlichen durchlässig sind, dieses nicht streuen und in ihrem Brechungsindex weitgehend dem betreffenden Gemisch angepaßt sind, z.B. Polystyrol, organophiles Siliciumdioxid, Bentonit, Kieselsäure, organophiles Aluminiumoxid, Glaspulver, kolloidaler Kohlenstoff sowie verschiedene Arten von Farbstoffen und Pigmenten. Diese Zusatzstoffe werden in Mengen verwendet, die mit den gewünschten Eigenschaften der erfindungsgemäßen Materialien variieren. Die Füllstoffe haben den Vorteil, daß sie die Festigkeit der erfindungsgemäßen Gemische verbessern, die Klebrigkeit verringern helfen und unter Umständen als farbgebende Mittel wirksam sind.

Die Gemische können ferner noch geeignete Flußmittel wie Calciumstearat und/oder Formtrennmittel wie Talkum in wirksamen Mengen enthalten.

Für die Verwendung der Gemische als photopolymerisierbare Kleber und Dichtungsmassen empfiehlt es sich, klebrigmachende Harze, z.B. Paraffinharze, Kollophoniumester, Polyterpene, Cumaron-Inden-Harze oder Verbindungen gemäß US-PS 4 133 731 zuzusetzen.

Der Anteil der gegebenenfalls angewendeten Zusatzstoffe soll im allgemeinen 50, insbesondere 40 Gew.% eines Gemisches nicht überschreiten.

Die Herstellung der Gemische aus den Komponenten weist keine methodischen Besonderheiten auf; es können die üblichen Knet-, Misch- und Lösungstechniken angewendet werden.

Die so erhaltenen Gemische können direkt als photovernetzbare Kleber und Dichtungsmassen verwendet oder zu photovernetzbaren Folien und zu Platten, insbesondere Druckplatten, Reliefplatten und Photoresists, weiterverarbeitet werden. Dazu werden sie in üblicher Weise durch Gießen aus einer Lösung, Heißpressen, Kalandrieren oder Extrudieren zu Flächengebilden der gewünschten Dicke geformt. Diese richtet sich im Falle der Formen in erster Linie nach dem Verwendungszweck der Flächengebilde und variiert im allgemeinen von 0,001 bis 7, insbesondere 0,025 bis 6,5 mm, da beispielsweise daraus hergestellte Druckformen dieser Dicke für die Mehrzahl der Drucktechniken geeignet sind. Im Falle Folien ist die Dicke beliebig.

Die Flächengebilde können als solche zu Druckformen, Reliefformen und photovernetzbaren Photoresists verarbeitet werden; es ist jedoch üblich, sie im Verbund mit anderen schichtenförmigen Materialien herzustellen und dann erst weiterzuverarbeiten. Ein solcher Verbund wird allgemein als "Mehrschichtenelement" und das darin enthaltene Flächengebilde als "reliefbildende Schicht (RS)" bezeichnet.

Üblicherweise enthält ein solches Mehrschichtenelement eine reliefbildende Schicht (RS), die mit einem dimensionsstabilen Träger (T) haftfest verbunden ist. Der dimensionsstabile Träger (T) wiederum kann mit einer weichelastischen Unterschicht (U) gemäß DE-OS 24 44 118 unterlegt sein. Des weiteren kann auf die dem Träger (T) abgewandte Seite der Schicht (RS) eine Deckschicht (DS) und/oder eine Deckfolie (DF) aufgebracht werden. Werden Deckschicht (DS) und Deckfolie (DF) gemeinsam verwendet, dann liegt (DS) der Schicht (RS) direkt auf, und es kann sich zwischen (DS) und (DF) noch eine Antihaftschicht (AS) befinden. Ferner kann eine haftfeste Verbindung zwischen (T) und (RS) und gegebenenfalls (RS) und (DF) mit Hilfe einer Haftschicht (HS) erreicht werden.

Als dimensionsstabile Träger (T) können Platten, Folien oder konische Röhren (sleeves) aus Metallen wie Stahl, Aluminium, Kupfer oder Nickel oder aus Kunststoffen wie Polyethylenterephthalat, Polybutylenterephthalat, Polyamid oder Polycarbonat verwendet werden. Daneben kommen noch Gewebe und Vliese, z.B. Glasfasergewebe oder Verbundmaterialien aus z.B. Glasfasern und Kunststoffen wie Polyethylenterephthalat in Frage.

Als Haftschichten (HS) werden mit Vorteil etwa 0,5 bis 40 µm dicke Haftlackschichten gemäß DE-OS 31 00 175 oder DE-OS 31 07 741 verwendet.

Geeignete Deckschichten (DS) sind im allgemeinen 0,5 bis 20 µm dick und können aus einem Polymeren bestehen, das lösliche, klebfreie, transparente und reißfeste Filme bildet, z.B. Polyamid, Copolyamid, Polyurethan, Polyvinylalkohol, Polyvinylpyrrolidon, Polyethylenoxid eines Molgewichts über 105 oder Cyclokautschuk mit einem hohen Cyclisierungsgrad. Gegebenenfalls kann (DS) mattiert sein.

Geeignete Deckfolien (DF) sind im allgemeinen 20 bis 150 µm dick und bestehen z.B. aus einem Polymeren wie Polyamid oder Polyethylenterephthalat.

Geeignete Antihaftschichten (AS) sind im allgemeinen 0,1 bis 0,5 µm dick und bestehen beispielsweise aus Silikonharzen gemäß EP 68 599.

Werden als Schichtträger (T) stark reflektierende Platten oder Folien verwendet, dann können sie

geeignete Lichthofschutzmittel, wie Ruß oder Mangandioxid, enthalten. Die Lichthofschutzmittel können aber als separate Schicht auf (T) aufgetragen werden oder in der Haftschicht (HS) oder der reliefbildenden Schicht (RS) enthalten sein.

Die Herstellung solcher Mehrschichtenelemente weist keine methodischen Besonderheiten auf und kann durch Auftragen der reliefbildenden Schicht (RS) auf dem Träger (T) mittels Gießen aus Lösung, Heißpressen, Kalandrieren oder Extrudieren erfolgen. Auf dieses Zweischichtenelement können dann die anderen Schichten in bekannter Weise aufgebracht werden. Es ist aber auch möglich, die Schicht (RS) zuerst auf die mit einer Deckschicht (DS) bedeckten Seite einer Deckfolie (DF) aufzutragen und anschließend die unbedeckte Seite der Schicht (RS) mit dem Träger (T) haftfest zu verbinden.

Aus den Flächengebilden, die aus den Gemischen bestehen, oder aus den Mehrschichtenelementen, die reliefbildende Schichten (RS) aus solchen Gemischen enthalten, können photovernetzte Druckformen, Reliefformen, Photoresists und Folien hergestellt werden. Diese Umwandlung von durch Photopolymerisation vernetzbaren Druckplatten, Reliefplatten, Photoresists oder Folien in durch Photopolymerisation vernetzte Druckformen, Reliefformen, Photoresists oder Folien bietet auch keine methodischen Besonderheiten.

Sie erfolgt - gegebenenfalls nach einer Vorbehandlung - durch bildmäßiges Belichten der Druckplatten, Reliefplatten und Photoresists mit aktinischem Licht einer Wellenlänge zwischen 230 und 450, vorteilhafterweise zwischen 300 und 450 nm durch aufgelegte Negativvorlagen hindurch, Auswaschen der unbelichteten und daher unvernetzten Anteile der Druckplatten, Reliefplatten und Photoresists mit Hilfe geeigneter Entwicklerlösungsmittel, Trocknen der so erhaltenen Formen, die aus einer Reliefschicht (RS′) bestehen oder diese enthalten, und gegebenenfalls Nachbehandeln der Formen. Im Falle der Folien erfolgt die Belichtung vollflächig. Es versteht sich von selbst, daß bei photovernetzten Folien, die durch vollflächige Belichtung mit aktinischem Licht hergestellt werden, die weiteren Verfahrensschritte entfallen.

Geeignete Lichtquellen für aktinisches Licht sind z.B. handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Geeignete Entwicklerlösungsmittel sind aromatische Kohlenwasserstoffe, z.B. Toluol oder Ethylbenzol; Chloralkane, z.B. 1,1,1-Trichlorethan, 1,1,2,2-Tetrachlorethan oder Tetrachlorethylen; Ketone, z.B. Methylisobutylketon; Mischungen solcher Lösungsmittel miteinander oder mit niederen Alkoholen, z.B. n-Butanol; oder Wasser oder wäßrige Basen.

Die Dicke der Reliefschicht (RS′) der Formen variiert je nach Anwendungszweck von 0,001 bis 7 mm, von Vorteil sind Dicken von 0,025 bis 6,5 mm.

Die in dieser Weise erhaltenen Druckformen können auf Druckzylinder aufgebracht, gegebenenfalls durch Coronaentladungen aufgerauht und für den Endlosdruck verwendet werden.

Die Gemische weisen bei ihrer Herstellung und Verarbeitung zahlreiche Vorteile auf. So lassen sie sich sehr leicht nach den üblichen Verfahren verarbeiten, wobei insbesondere ihre gute Dosierbarkeit in Krümelform das Beschicken von Extrudern erleichtert, wodurch sich im allgemeinen eine Mitverwendung von Trennmitteln erübrigt. Die verarbeiteten Massen und Formen sind klar und transparent, was vor allem erlaubt, photovernetzte Druckformen, Reliefformen und Photoresists mit Reliefschichten (RS′) von sehr hoher Relieftiefe mit gutem Flankenaufbau herzustellen. Dies ist z.B. für das Bedrucken rauher, welliger Oberflächen, z.B. von Wellpappe, Kartonagen oder Servietten unbedingt erforderlich. Reliefhöhen von über 3 mm sind daher ohne Probleme wie bei konventionell geprägten Gummiklischees herstellbar, ohne daß es in der Tiefe der Schichten zum "Zupolymerisieren" kommt. Nicht zuletzt erlaubt die Klarheit der Gemische kurze Belichtungszeiten, ohne daß dies einen nicht aktzeptablen Polymerisationsgradienten in den Reliefschichten (RS′) zur Folge hätte. Die belichteten Massen und Formen sind stabil gegenüber äußerden chemischen und physikalischen Einflüssen und nicht klebrig. Insbesondere besitzen die Druckformen eine hohe Beständigkeit gegenüber Druckfarbenlösungsmitteln und eine hohe Abriebfestigkeit, was sehr hohe Druckauflagen ermöglicht. Der Hauptvorteil der photopolymerisierten Massen und Formen auf der Basis der erfindungsgemäßen Polymerisate ist ihre Rißbeständigkeit.

Zusätzlich zu den vorstehend angegebenen Verwendungszwecken können die erfindungsgemäßen Polymerisate auch noch für die Herstellung von Schmelzklebern, Haftvermittlern, Antidröhnmassen, Dämpfungsmassen für mechanische Stöße oder von Lacken verwendet werden. Desweiteren eignen sie sich als Zusatzstoffe für Thermoplaste, synthetische Kautschuke oder Bitumen.

## Beispiele

In den folgenden Beispielen ist unter "Säurezahl" die Menge von 100 %iger KOH in mg zu verstehen, die zur Neutralisation der in 1 g Produkt enthaltenen freien Säurefunktionen benötigt wird. Die Shore-A-Härte wurde nach DIN 53 505 und die Quellung der Proben in Gew.% nach 24stündiger Lösungsmittelbehandlung mit einem Gemisch aus Ethanol (7 Gew.-Teile) und Essigsäureethylester (3 Gew.-Teile) bestimmt. Die Neigung zur Rißbildung wurde in einer Ozonkammer bei einer Ozonkonzentration von 50 pphm (parts per hundred million) und bei einer Temperatur von 25°C an 10 cm langen Proben, die einer 10 %igen Längendehnung unterworfen waren, bestimmt; Kriterium war hierbei, ob innerhalb von 10 Stunden Risse auftraten. Der "melt flow index" (MFI) wurde bei 190°C mit einer Auflagekraft von 21,18 N (2,16 kp) oder bei 160°C mit einer Auflagekraft von 3,19 N (325 p) bestimmt.

Herstellung von Copolymerisaten A

Für die erfindungsgemäßen Beispiele wurden eine Reihe von Copolymerisaten A nach der Lehre der DE-PS 23 41 462, US-PS 3 264 272 oder der europäischen Patentanmeldung EP-A 224 029 hergestellt. Die Zusammensetzung der Copolymerisate A zeigt Tabelle 1, wichtige, für eine Verwendung relevante Eigenschaften dieser Copolymerisate zeigt Tabelle 2.

Tabelle 1

| Copolymerisate A | | | | | | | | |
|---|---|---|---|---|---|---|---|---|
| Copolymerisat/Monomere | Gehalt an einpolymerisierten Monomeren (%) | | | | | | | |
| | $A_1$ | $A_2$ | $A_3$ | $A_4$ | $A_5$ | $A_5$ | $A_7$ | $A_5$ |
| Ethylen | 57,1 | 56,4 | 54,9 | 57,4 | 52 | 62,3 | 51,6 | 56,6 |
| Acrylsäure | 18,9 | 18,6 | 21,1 | 17,6 | 17 | 13,7 | 14,4 | 14,9 |
| n-Butylacrylat | 24 | 25 | 24 | - | 19 | - | - | - |
| ω-Methyl-poly-(ethylenoxid)-α-ylacrylat | - | - | - | 25 | 12 | 9 | 24 | 11 |
| 2-Ethylhexylacrylat | - | - | - | - | - | 15 | 10 | 17,5 |

Tabelle 2

| Eigenschaften der Copolymerisate A | | | | | | | | |
|---|---|---|---|---|---|---|---|---|
| Copolymerisat/Eigenschaft | $A_1$ | $A_2$ | $A_3$ | $A_4$ | $A_5$ | $A_5$ | $A_7$ | $A_5$ |
| MFI* | $48^1$ | $7,5^1$ | $17^1$ | $18^2$ | $15^2$ | $26^2$ | $28^2$ | $26^2$ |
| Shore A-Härte | 40 | 42 | 32 | 34 | 22 | 29 | 33 | 29 |

* MFI = melt flow index;
1 = 190°C/21,18 N (2,16 kp);
2 = 160°C/ 3,19 N (325 p);

Herstellung von maleiniertem und anschließend teilverestertem Polybutadien (Molmasse 1300, Gehalt an 1,2-Struktureinheiten: 90 %)

Zu Vergleichszwecken wurde ein maleiniertes Polybutadien, das in einer weiteren Stufe mit 2-Hydroxiethylmethacrylat teilverestert wurde, hergestellt.

Maleinierung von flüssigem Polybutadien

In einem 4 l Dreihals-Kolben, ausgestattet mit einem mechanischen Rührer, einem Rückflußkühler, einem Thermometer und einem Stickstoffspülanschluß, wurden 2500 g des Polybutadiens, 500 g Maleinsäureanhydrid, 100 g Xylol und 25 g Hydrochinon als Inhibitor vorgelegt. Anschließend wurde der Reaktionskolben während 5 Minuten mit Stickstoff gespült und der Inhalt unter Stickstoffatmosphäre und ständigem Rühren auf 190°C erhitzt. Nach 6 Stunden war die Reaktion weitgehend beendet; die Umsätze (bezogen auf eingesetztes Maleinsäureanhydrid) lagen bei mehr als 90 Mol.%. Zur Umsatzbestimmung wurde eine kleine Probe in Ethanol ausgefällt, und nach zweimaligem Umfällen mit Ethanol aus Toluol und nach Hydrolyse ihre Säurezahl ermittelt. Es ergab sich ein Maleinierungsgrad von 15 Gew.%, bezogen auf

das Polybutadien.

Teilveresterung des maleinierten Polybutadiens

In einem 2 l Dreihals-Kolben, ausgestattet mit Rührer, Rückflußkühler, Thermometer und Tropftrichter wurden 654 g des maleinierten Polybutadiens, 1 l Toluol (über Molekularsieb getrocknet), 3 g p-Dimethylaminopyridin, 3 g N-Nitrosodiphenylamin und 196 g 2-Hydroxyethylmethacrylat bei Raumtemperatur gemischt und anschließend während 3 bis 5 Stunden bei 50 bis 90 °C gerührt. Nach dieser Zeit war die für das Maleinsäureanhydrid-Polybutadien-Addukt charakteristische IR-Absorptionsbande bei 1780 $cm^{-1}$ verschwunden. Das Produkt wurde durch seine Säurezahl charakterisiert. Diese zeigte, daß mehr als 90 Mol.% der ursprünglich vorhandenen Bernsteinsäureanhydrid-Gruppen umgesetzt waren. Die aufgenommene Menge an 2-Hydroxiethylmethacrylat entsprach 15 Gew.%, bezogen auf das Ausgangspolymere. Das Produkt war eine klare, hochviskose, stark klebrige Flüssigkeit.

Vergleichsversuch

86,7 g des maleinierten und teilveresterten Polybutadiens, 10 g Tripropylenglykoldiacrylat, 3 g Benzildimethylacetal und 0,3 g 2,6-Di-tert.-butyl-p-kresol wurden in Toluol aufgelöst und mit Toluol auf einen Feststoffgehalt von 40 %, bezogen auf die Gesamtmenge der Lösung, eingestellt. Die Lösung wurde auf eine 125 µm dicke Polyesterfolie gegossen und das Lösungsmittel entfernt. Die unbelichtete, photopolymerisierbare oder photovernetzbare reliefbildende Schicht war flüssig, hochviskos und sehr klebrig. Nach der Belichtung der mit einer 10 µm dicken Polyesterfolie abgedeckten Flüssigplatte durch eine Negativvorlage hindurch und Auswaschen mit ammoniakalisch-wäßriger Lösung erhielt man Klischees mit leicht klebriger Oberfläche aber hoher Auflösung. Die entwickelten Schichten besaßen einen Deformationsweg von 138 µm pro 1000 µm Schichtdicke bei einem Auflagedruck von 980,7 N (100 kp) pro 0,6 $cm^2$. Bei längerer Lagerung kam es zu Versprödungen, und es traten Risse auf.

Herstellung der erfindungsgemäßen Polymerisate

Beispiel 1

693 g des Copolymerisats $A_1$ wurden zusammen mit 423 mg p-Dimethylaminopyridin und 423 mg 2,6-Di-tert.-butyl-p-kresol in 2,2 l trockenem Tetrahydrofuran bei 40 bis 50 °C gelöst. Zu dieser Lösung wurden innerhalb von 30 Minuten 42,3 g Glycidylmethacrylat zugetropft. Die resultierende Lösung wurde während 5 Stunden bei 50 °C gerührt. Nach dem Entfernen des Lösungsmittels erhielt man ein transparentes, weichelastisches Polymerisat mit einer Säurezahl von 117. Der Gehalt an freiem Glycidylmethacrylat war kleiner als 0,3 Gew.%, bezogen auf das Produkt.

Beispiel 2

500 g des Copolymerisats $A_3$ wurden wie in Beispiel 1 in Gegenwart von 305 mg N-Methylimidazol und 305 mg N-Nitrosodiphenylamin in einer Mischung aus Toluol/Methylethylketon (Volumenverhältnis 4:1) mit 30,5 g Glycidylmethacrylat umgesetzt. Nach Entfernen des Lösungsmittels erhielt man ein transparentes, weichelastisches Polymerisat mit einer Säurezahl von 115 und einem Gehalt an freiem Glycidylmethacrylat von kleiner 0,3 %, bezogen auf das Produkt.

Beispiel 3

20 g des Copolymerisats $A_4$ wurden zusammen mit 0,2 g 2,6-Di-tert.-butyl-p-kresol, 25 mg p-Dimethylaminopyridin, 25 mg N-Nitrosodiphenylamin und 4,88 g Glycidylmethacrylat während 30 Minuten bei 125 °C auf einem Kneter intensiv geknetet. Man erhielt ein transparentes Polymerisat mit einem Gehalt von freiem Glycidylmethacrylat von 1,1 %, bezogen auf das Produkt.

Beispiel 4

20 g des Copolymerisats $A_2$ wurden zusammen mit 0,2 g 2,6-Di-tert.-butyl-p-kresol und 1,22 g Glycidylmethacrylat während 30 Minuten bei 125 °C intensiv geknetet. Man erhielt ein transparentes Polymerisat mit einer Säurezahl von 118. Die Probe wird anschließend bei 80 °C 23 Stunden lang

getempert, ohne daß sich die Säurezahl veränderte.

Beispiel 5

1420 g Copolymerisats $A_8$ wurden zusammen mit 100 g p-Dimethylaminopyridin, bei 160 °C in einem Zweischneckenextruder aufgeschmolzen. Zu der Schmelze wurden über eine Pumpe 580 g Glycidylmethacrylat, das 0,6 % 2,6-Di-tert.-butyl-p-kresol enthielt, zudosiert. Nach einer Verweilzeit von 5 Minuten wurde das Material durch eine Breitschlitzdüse ausgetragen. Man erhielt ein transparentes weichelastisches Polymerisat mit einem Gehalt von freiem Glycidylmethacrylat von 0,18 %, bezogen auf das Produkt.

Beispiel 6

250 g des Copolymerisates $A_8$ gemäß Tabelle 1 wurden zusammen mit 0,6 g p-Dimethylaminopyridin und 1,5 g 2,6-Di-tert.-butyl-p-kresol in 730 ml Tetrahydrofuran gelöst. Zu dieser Lösung tropfte man innerhalb 30 Minuten 30,5 g Glycidylmethacrylat zu. Die Lösung wurde anschließend 10 Stunden lang bei 60 °C gerührt und das Lösungsmittel abgezogen. Man erhielt ein transparentes, weichelastisches Polymerisat mit einem Gehalt an freiem Glycidylmethacrylat von kleiner 1 %, bezogen auf das Produkt.

Beispiel 7

200 g des Copolymerisates $A_4$ gemäß Tabelle 1 wurden in der Gegenwart von 1,2 g p-Dimethylaminopyridin und 3 g 2,6-Di-tert.-butyl-p-kresol mit 61 g Glycidylmethacrylat gemäß Beispiel 1 zu einem transparenten, weichelastischen Polymerisat mit einem Gehalt an freiem Glycidylmethacrylat von kleiner 1 %, bezogen auf das Produkt, umgesetzt.

Versuche zur Verwendung der erfindungsgemäßen Polymerisate für die Herstellung von Druckplatten und Druckformen.

Verwendungsbeispiel 1

Ein Gemisch wurde durch Extrusion von 7820 g des Copolymerisates $A_1$ gemäß Tabelle 1, enthaltend, bezogen auf $A_1'$, 2,6 % 2,6-Di-tert.-butyl-p-kresol und 0,061 % p-Dimethylaminopyridin, 500 g Trimethylolpropandiacrylat, 1000 g $\omega$-Methyl-poly(ethylenoxid)-$\alpha$-yl-acrylat und 200 g Benzildimethylacetal in einem Zweischneckenextruder hergestellt.

Dazu wurde das stabilisierte Copolymerisat $A_1$ über eine Förderschnecke gleichmäßig in den Extruder eingetragen und bei 160 °C aufgeschmolzen. Die übrigen Komponenten wurden über Pumpen der Schmelze zudosiert und das Gemisch aus einer Breitschlitzdüse auf eine 125 µm dicke Polyesterfolie so ausgetragen, daß eine Schichtdicke von 2800 µm resultiert. Diese Schicht wurde 20 Minuten lang durch eine Negativvorlage belichtet und mit 0,5 %iger wäßriger Natronlauge, die 0,001 % eines Natriumparaffinsulfonats als Tensid enthielt, bei 50 °C entwickelt. Nach dem Trocknen erhielt man ein Klischee mit klebfreier Oberfläche und einer Shore A-Härte von 65 bis 67. Die Quellung in wäßrigen flexotypischen Druckfarben lag unter 2 %. Auch nach längerer Lagerung der Reliefschicht zeigten sich keine Versprödungen. Es waren keine Risse zu beobachten.

Verwendungsbeispiel 2

Es wurden 20 g des Copolymerisats $A_1$ gemäß Tabelle 1, 0,2 g 2,6-Di-tert.-butyl-p-kresol, 2,44 g Glycidylmethacrylat und 25 mg p-Dimethylaminopyridin durch 30 minütiges Kneten bei 120 °C in einem Plastographen gemischt. Dazu wurden nacheinander 0,83 g 1,6-Hexandioldiacrylat, 0,43 g 1,6-Hexandioldimethacrylat, 1,25 g Tetraethylenglykolmonomethylether und 0,7 g Benzildimethylacetal zugegeben und weitere 10 Minuten bei 120 °C geknetet. Man erhielt nach dem Abkühlen ein transparentes Gemisch, das zwischen einer Stahlunterlage und einer Polyesterfolie in einer Heißpresse bei 120 °C zu einer Schichtdicke von 1200 µm gepreßt wurde. Die Schicht wurde anschließend durch eine Negativvorlage hindurch belichtet, die Polyesterfolie entfernt und die Schicht mit einem Bürstenwascher in 0,5 %iger wäßriger Natronlauge bei 40 °C ausgewaschen. Nach dem Trocknen erhielt man eine Reliefschicht mit einer Auswaschtiefe von 650 µm und einer Härte von 80 Shore A. Die Reliefschicht wies auch bei längerer Lagerung keine Versprödungen auf. Risse waren nicht zu beobachten.

Verwendungsbeispiel 3

20 g Copolymerisat $A_1$ gemäß Tabelle 1, 0,2 g 2,6-Di-tert.-butyl-p-kresol, 1,22 g Glycidylmethacrylat und 25 mg p-Dimethylaminopyridin wurden durch 30 minütiges Kneten bei 120 °C in einem Plastographen intensiv durchmischt, mit 0,7 g Benzildimethylacetal versetzt und weitere 10 Minuten bei 120 °C geknetet. Das Gemisch wurde gemäß Verwendungsbeispiel 2 zu einer Platte von 1300 µm Dicke gepreßt und durch eine Negativvorlage hindurch belichtet. Nach dem Entwickeln der Schicht in einer 0,5 %igen wäßrigen Natronlauge bei 40 °C erhielt man ein Klischee mit einer Auswaschtiefe von 600 µm und einer Shore A-Härte von 63. Die Quellbeständigkeit gegenüber flexotypischen Wasserfarben war ausgezeichnet. Auch nach längerer Lagerung wurde das Klischee nicht spröde. Risse waren nicht zu beobachten.

Verwendungsbeispiel 4

Ein Gemisch wurde nach Verwendungsbeispiel 2 aus 75 g Copolymerisat $A_2$ gemäß Tabelle 1, 7 g Glycidylmethacrylat, 10 g Poly(ethylenoxid)dimethacrylat, 5 g ω-Methyl-poly(ethylenoxid)-α-yl-acrylat, 2,8 g Benzildimethylacetal, 0,18 g N-Nitrosodiphenylamin und 0,02 g p-Dimethylaminopyridin hergestellt.

Die daraus nach Verwendungsbeispiel 2 hergestellten Klischees hatten eine Reliefhöhe von 700 µm und eine Shore A-Härte von 61. Sie versprödeten nicht nach längerer Lagerungszeit. Risse waren nicht zu beobachten.

Verwendungsbeispiel 5

75 g Copolymerisat $A_3$ gemäß Tabelle 1, 7 g Glycidylmethacrylat, 15 g eines Umsetzungsprodukts aus 1 Mol Glycerin, 3 Mol Epichlorhydrin und 3 Mol Acrylsäure sowie 3 g Benzildimethylacetal wurden durch 30 minütiges Kneten bei 120 °C in einem Plastographen intensiv durchmischt.

Das so erhaltene Gemisch wurde, wie in Verwendungsbeispiel 2 beschrieben, zu einer 1300 µm dicken Schicht verpreßt. Die Oberfläche der unbelichteten Schicht wurde mit einer 3 µm dicken Schicht aus Polyvinylalkohol überzogen. Die Schicht wurde anschließend durch eine Negativvorlage hindurch belichtet, und danach während 15 Minuten in 0,5 %iger wäßriger ammoniakalischer Lösung entwickelt. Man erhielt ein Klischee mit 700 µm Relieftiefe und einer Shore A-Härte von 70. Das Klischee zeigte auch nach längerer Lagerung keine Versprödungen. Risse traten nicht auf.

Verwendungsbeispiel 6

250 g des Copolymerisats $A_4$ gemäß Tabelle 1 wurden zusammen mit 600 mg p-Dimethylaminopyridin und 1,5 g 2,6-Di-tert.-butyl-p-kresol in 750 ml Tetrahydrofuran gelöst. Dazu tropfte man innerhalb von 30 Minuten 61 g Glycidylmethacrylat. Die Reaktionsmischung wurde anschließend 10 Stunden bei 60 °C gerührt. Zu der so erhaltenen Lösung gibt man nacheinander 35,6 g Tetraethylenglykoldiacrylat, 3,6 g Benzildimethylacetal, 1,4 g N-Nitrosocyclohexylhydroxylamin-Calciumsalz, 0,11 g Safranin T (C.I. 50240) und 1,5 g 2,6-Di-tert.-butyl-p-kresol. Die Lösung wurde auf eine Konzentration von 60 % Feststoff eingeengt und bei 60 °C auf eine 125 µm Polyesterfolie so ausgegossen, daß eine Trockenschichtdicke von 650 µm resultierte. Die nach Verwendungsbeispiel 2 hergestellten Klischees besaßen eine Shore A-Härte von 67. Auch nach längerer Lagerung wurden die Klischees nicht spröde, sondern behielten ihre ausgezeichnete Elastizität.

Verwendungsbeispiel 7

250 g des Copolymerisats $A_6$ gemäß Tabelle 1 wurden nach Verwendungsbeispiel 6 mit 61 g Glycidylmethacrylat umgesetzt und mit Zusatzstoffen zu einem Gemisch verarbeitet. Die daraus nach Verwendungsbeispiel 2 hergestellten Klischees wiesen eine Shore A-Härte von 73 auf. Sie besaßen eine ausgezeichnete Elastizität und zeigten in flexotypischen Wasserfarben eine Gewichtsquellung von unter 5 %.

Verwendungsbeispiel 8

250 g des Copolymerisats $A_7$ gemäß Tabelle 1 wurden nach Verwendungsbeispiel 6 in der Gegenwart von 0,3 g p-Dimethylaminopyridin und 1,4 g 2,6-Di-tert.-butyl-p-kresol mit 30,5 g Glycidylmethacrylat umgesetzt. Zu der erhaltenen Lösung gibt man nacheinander 1,8 g 2,6-Di-tert.-butyl-p-kresol,0,11 g Safranin

T (C.I. 50240), 1,45 g N-Nitrosocyclohexylhydroxylamin-Calciumsalz, 3,6 g Benzildimethylacetal und 36,2 g ω-Methyl-poly(ethylenoxid)-α-yl-acrylat. Die Lösung wurde auf eine Konzentration von 60 % Feststoff eingeengt und bei 60 °C auf eine 125 µm Polyesterfolie so ausgegossen, daß eine Trockenschichtdicke von 500 µm resultierte. Die nach Verwendungsbeispiel 2 hergestellten Klischees besaßen eine Shore A-Härte von 60 und eine Gewichtsquellung in flexotypischen Wasserfarben von unter 5 %.

Verwendungsbeispiel 9

Das Copolymerisat $A_8$ gemäß Tabelle 1 wurde nach Verwendungsbeispiel 8 mit Glycidylmethacrylat umgesetzt und mit Zusatzstoffen zu einem Gemisch verarbeitet, wobei anstelle von Benzildimethylketal die gleiche Menge 2,4,6-Trimethylbenzoyldiphenylphosphinoxid als Photoinitiator verwendet wurde. Die daraus nach Verwendungsbeispiel 8 hergestellten Klischees besaßen eine Shore A-Härte von 52 und eine ausgezeichnete Bildauflösung.

Verwendungsbeispiel 10

250 g des Copolymerisats $A_1$ gemäß Tabelle 1 wurden nach Verwendungsbeispiel 6 mit 30,5 g Glycidylmethacrylat in der Gegenwart von 0,3 g p-Dimethylaminopyridin und 1,4 g 2,6-Di-tert.-butyl-p-kresol umgesetzt. Zu der 60 °C warmen Lösung gab man nacheinander 15,2 g Tetraethylenglykoldiacrylat, 1,52 g 2,4,6-Trimethylbenzoyldiphenylphosphinoxid, 0,76 g 2,6-Di-tert.-butyl-p-kresol, 1,21 g N-Nitrosocyclohexylhydroxylamin-Calciumsalz und 0,09 g Safranin T (C.I. 50240). Die Lösung wurde auf eine Konzentration von 63 Gew.% Feststoff eingeengt und bei 60 °C auf eine mit Polyvinylalkohol bedeckte 125 µm Polyesterfolie so ausgegossen, daß eine Trockenschichtdicke von 1050 µm resultierte. Die daraus nach Verwendungsbeispiel 2 hergestellten Klischees besaßen eine Shore A-Härte von 49 und eine Gewichtsquellung in flexotypischen Wasserfarben von unter 3 %. Die Belichtungszeiten der lichtempfindlichen Schichten ließen sich zwischen 10 und 40 Minuten variieren, ohne daß die Auflösung der Bildelemente nennenswert beeinträchtigt wurde.

Verwendungsbeispiel 11

Ein Gemisch wurde nach Verwendungsbeispiel 1 aus 8300 g des Copolymerisats $A_8$ gemäß Tabelle 1, 1000 g Glycidylmethacrylat, stabilisiert mit 1 % 2,6-Di-tert.-butyl-p-kresol, 500 g Trimethylolpropantriacrylat, 132 g Benzildimethylketal, 25 g 2,6-Di-tert.-butyl-p-kresol, 40 g N-Nitrosocyclohexylhydroxylamin-Calciumsalz und 3 g Safranin T (C.I. 50240) durch Extrusion in einem Zweischneckenextruder hergestellt.

Die aus dem Gemisch hergestellte lichtempfindliche Schicht wurde während 25 Minuten durch eine Negativvorlage hindurch belichtet und gemäß Verwendungsbeispiel 1 ausgewaschen. Nach dem Trocknen erhielt man ein Klischee mit einer Shore A-Härte von 54 und einer hervorragenden Elastizität. Auch nach längerer Lagerung der Reliefschicht zeigten sich keine Versprödungen. Risse traten nicht auf.

Verwendungsbeispiel 12

250 g des Copolymerisats $A_8$ gemäß Tabelle 1 wurden nach Verwendungsbeispiel 6 mit 30,5 g Glycidylmethacrylat in der Gegenwart von 0,15 g p-Dimethylaminopyridin und 1 g 2,6-Di-tert.-butyl-p-kresol umgesetzt. Zu der erhaltenen Lösung gab man nacheinander 15,2 g N,N-Diethylaminoethylacrylat, 1,52 g Benzildimethylacetal, 0,76 g 2,6-Di-tert.-butyl-p-kresol, 0,09 g Safranin T (C.I. 50240) und 1,21 g N-Nitrosocyclohexylhydroxylamin-Calciumsalz. Die Lösung wurde auf eine Konzentration von 56 Gew.% eingeengt und bei 50 °C auf eine Polyesterfolie so ausgegossen, daß eine Trockenschichtdicke von 1000 µm resultierte. Die nach Verwendungsbeispiel 2 hergestellten Klischees besaßen eine Shore A-Härte von 46. Sie zeigten in Wasser eine Gewichtsquellung von unter 2 %.

Verwendungsbeispiel 13

82 g Polymerisat nach Beispiel 6, 5 g Bis(acetylacetonato)-Zn(II), 6,6 g 1,6-Hexandioldiacrylat, 3,4 g 1,6-Hexandioldimethacrylat und 3,0 g Benzildimethylacetal wurden in Tetrahydrofuran gelöst und die Endkonzentration der Lösung auf 15 %, bezogen auf das Gesamtgewicht der Lösung, eingestellt. Die Lösung wurde auf eine 125 µm dicke Polyethylenterephthalatfolie gegossen, so daß eine Trockenschichtdicke von 1500 µm resultierte. Die so hergestellte Schicht war völlig klar und besaß eine klebfreie Oberfläche. Nach dem Aufkaschieren einer 10 µm dicken Polyethylenterephthalatfolie wurde die Schicht

während 20 Minuten durch eine Negativvorlage hindurch mit aktinischem Licht belichtet, die 10 µm dicke Polyesterfolie entfernt und die bildmäßig belichtete Schicht während 15 Minuten in einer Mischung aus Tetrachlorethylen-n-Butanol (Volumenverhältnis 4:1) entwickelt. Nach der Trocknung wurde eine Druckform mit einer Relieftiefe von 800 µm und sehr guter Auflösung erhalten. Die Druckform besaß eine sehr hohe Flexibilität, eine Shore A-Härte von 55 und konnte mehrfach, ohne zu brechen, auf kleine Druckzylinder aufgespannt werden. Sie war lagerstabil und zeigte selbst nach längerer Lagerzeit keine Versprödung. Risse waren nicht zu beobachten.

Verwendungsbeispiel 14

Ein Gemisch wurde gemäß Verwendungsbeispiel 12 aus den nachstehenden Komponenten hergestellt: 87,5 g Polymerisat nach Beispiel 6, 0,5 g Bis(acetylacetonato)-Zn(II), 10 g Tetraethylenglykoldiacrylat und 2 g 2,4,6-Trimethylbenzoyldiphenylphosphinoxid. Die so erhaltene Schicht war völlig klar. Nach dem Aufkaschieren einer 10 µm dicken Polyethylenterephthalatfoliewurde die Schicht während 15 Minuten durch eine Negativvorlage hindurch belichtet, die 10 µm dicke Polyesterfolie entfernt und die bildmäßig belichtete Schicht während 20 Minuten in 0,5 %iger wäßriger ammoniakalischer Lösung bei 55 °C entwickelt. Nach dem Trocknen wurde eine Reliefform mit einer Relieftiefe von 900 µm und einer Shore A-Härte von 48 erhalten. Die Druckform zeigte eine sehr hohe Flexibilität und hatte beim Druck eine hohe Auflagenbeständigkeit. Es traten keine Risse auf.

Verwendungsbeispiel 15

20 g des Polymerisats $A_8$ gemäß Tabelle 1, 0,2 g 2,6-Di-tert.-butyl-p-kresol, 1,1 g Tetraethylenglykoldiacrylat, 0,11 g 2,4,6-Trimethylbenzoyldiphenylphosphinoxid, 0,09 g des Calciumsalzes des N-Nitrosocyclohexylhydroxylamins, 0,2 g Magnesiumoxid und 0,01 g Safranin T (C.I. 50240) wurden während 30 Minuten bei 120 °C intensiv in einem Plastographen geknetet. Nach dem Abkühlen erhielt man eine transparente Mischung, die mittels einer Heizpresse bei 120 °C auf eine 125 µm Polyesterfolie so aufgebracht wurde, daß eine Schichtdicke von 1500 µm resultierte. Nach dem Aufbringen einer 3 µm dicken Schicht an hochverseiftem Polyvinylalkohol wurde die Schicht während 15 Minuten durch eine Negativvorlage hindurch belichtet und während 20 Minuten bei 60 °C mit 0,5 %iger wäßriger Natronlauge entwickelt. Nach der Trocknung wurde eine Druckform mit einer Relieftiefe von 800 µm und einer Shore A-Härte von 60 erhalten. Die Druckform besaß eine ausgezeichnete Flexibilität und zeigte beim Drucken eine hohe Auflagebeständigkeit. Es traten keine Risse auf.

Verwendungsbeispiel 15

Ein Gemisch wurde gemäß Verwendungsbeispiel 12 aus den nachfolgenden Komponenten hergestellt: 85,02 g Polymerisat nach Beispiel 7, 3 g Lithiumhydroxid, 10 g 1,1,1-Trimethylolpropantriacrylat, 1,3 g Benzildimethylacetal, 0,25 g 2,6-Di-t-butyl-p-kresol, 0,4 g des Calciumsalzes des N-Nitrosocyclohexylhydroxylamins und 0,03 g Safranin T (C.I. 50240). Die so erhaltene Schicht wurde während 20 Minuten durch ein Negativ belichtet und anschließend während 20 Minuten in einer 0,5 %igen wäßrigen Natronlaugelösung, die 1 % Ammoniak enthielt, bei 60 °C entwickelt. Nach dem Trocknen wurde eine Reliefform mit einer Relieftiefe von 600 µm erhalten. Die Druckform besaß eine Shore A-Härte von 82 und eine gute Flexibilität und zeigte selbst nach längerer Lagerung keine Versprödung. Risse traten nicht auf.

**Patentansprüche**
**Patentansprüche für folgende Vertragsstaaten : CH, DE, FR, GB, IT, NL, SE**

**1.** Vernetzbare feste kautschukelastische Polymerisate in Säureform oder in Form ihrer Salze, erhältlich durch polymeranaloge Umsetzung von
A) einem Copolymerisat aus
$a_1$) 30 bis 70 Gew.-Teilen Ethylen,
$a_2$) 5 bis 40 Gew.-Teilen Acrylsäure und/oder Methacrylsäure und
$a_3$) 5 bis 50 Gew.-Teilen eines oder mehrerer Vinylester, Vinylether, Acrylsäureester, Methacrylsäureester, Acrylsäureamide und/oder Methacrylsäureamide
mit
B) Verbindungen, durch welche seitenständige Reste der allgemeinen Formel I

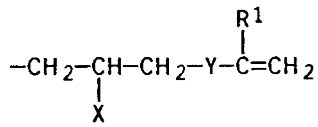 I,

in denen
X eine Hydroxi-, eine Amino- oder eine Mercapto-Gruppe,
Y eine Ester-, eine Amid-, eine Ether- oder eine $C_1$- bis $C_{10}$-Alkylen-Gruppe und
$R^1$ ein Wasserstoffatom oder eine Methylgruppe bedeuten,
und
C) gegebenenfalls weitere seitenständige Reste der allgemeinen Formel II

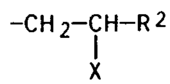 II,

in denen
$R^2$ eine polare Gruppe, ein Wasserstoffatom oder eine weitere Gruppe X bedeutet, in das Copolymerisat A eingeführt werden.

2. Polymerisate nach Anspruch 1, dadurch gekennzeichnet, daß das Copolymerisat A aus
$a_1$) 40 bis 60 Gew.-Teilen Ethylen,
$a_2$) 8 bis 30 Gew.-Teilen Acrylsäure und/oder Methacrylsäure und
$a_3$) 20 bis 40 Gew.-Teilen eines oder mehrerer Vinylester, Vinylether, Acrylsäureester, Methacrylsäureester, Acrylsäureamide und/oder Methacrylsäureamide
besteht.

3. Polymerisate nach den Ansprüchen 1 und 2, dadurch gekennzeichnet, daß sie durch polymeranaloge Umsetzung eingeführte seitenständige Reste C enthalten, in denen $R^2$ in Formel II einen $\omega$-Alkylpoly-(ethylenoxid)-$\alpha$-oxyl-Rest bedeutet.

4. Polymerisate nach den Ansprüchen 1 bis 3, dadurch gekennzeichnet, daß sie in Form ihrer Metall-, Ammonium- oder Hydraziniumsalze oder als Salze mehrfachfunktioneller Amine vorliegen.

5. Polymerisate nach den Ansprüchen 1 bis 4, dadurch gekennzeichnet, daß Komponente $a_3$ Vinylacetat ist.

6. Polymerisate nach den Ansprüchen 1 bis 4, dadurch gekennzeichnet, daß Komponente $a_3$ Vinyl-1-butylether ist.

7. Polymerisate nach den Ansprüchen 1 bis 4, dadurch gekennzeichnet, daß Komponente $a_3$ n-Butylacrylat, 2-Ethylhexylacrylat, Dicyclopentadienylacrylat und/oder $\omega$-Methyl-poly(ethylenoxid)-$\alpha$-yl-acrylat ist.

8. Verwendung der Polymerisate gemäß einem der Ansprüche 1 bis 7 zur Herstellung von photovernetzbaren Druckplatten, Reliefplatten und Photoresists.

9. Verwendung der Polymerisate gemäß einem der Ansprüche 1 bis 7 zur Herstellung von photovernetzten Druckformen, Reliefformen und Photoresists.

10. Photovernetzbare Druckplatten, Reliefplatten und Photoresists, hergestellt unter Verwendung von Polymerisaten gemäß einem der Ansprüche 1 bis 7.

**Patentansprüche für folgende Vertragsstaaten : AT, ES**

1. Verfahren zur Herstellung vernetzbarer fester kautschukelastischer Polymerisate in Säureform oder in

Form ihrer Salze, bei dem man seitenständige, olefinisch ungesättigte Reste B und gegebenenfalls weitere seitenständige Reste C durch polymeranaloge Umsetzung in ein Copolymerisat A einführt, dadurch gekennzeichnet, daß man hierzu

A) ein Copolymerisat aus

$a_1$) 30 bis 70 Gew.-Teilen Ethylen,

$a_2$) 5 bis 40 Gew.-Teilen Acrylsäure und/oder Methacrylsäure und

$a_3$) 5 bis 50 Gew.-Teilen eines oder mehrerer Vinylester, Vinylether, Acrylsäureester, Methacrylsäureester, Acrylsäureamide und/oder Methacrylsäureamide

und

B) Verbindungen, welche seitenständige Reste der allgemeinen Formel I bilden

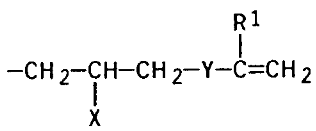

I,

in denen

X eine Hydroxi-, eine Amino- oder eine Mercapto-Gruppe,

Y eine Ester-, eine Amid-, eine Ether- oder eine $C_1$- bis $C_{10}$-Alkylen-Gruppe und

$R^1$ ein Wasserstoffatom oder eine Methylgruppe bedeuten,

und

C) gegebenenfalls weitere Verbindungen, welche seitenständige Reste der allgemeinen Formel II bilden

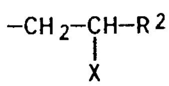

II,

in denen

$R^2$ eine polare Gruppe, ein Wasserstoffatom oder eine weitere Gruppe X bedeutet,

verwendet.

**2.** Verfahren nach Anspruch 1, dadurch gekennzeichnet, daß man hierzu ein Copolymerisat (A) aus

$a_1$) 40 bis 60 Gew.-Teilen Ethylen,

$a_2$) 8 bis 30 Gew.-Teilen Acrylsäure und/oder Methacrylsäure und

$a_3$) 20 bis 40 Gew.-Teilen eines oder mehrerer Vinylester, Vinylether, Acrylsäureester, Methacrylsäureester, Acrylsäureamide und/oder Methacrylsäureamide

verwendet.

**3.** Verfahren nach einem der Ansprüche 1 und 2, dadurch gekennzeichnet, daß man hierzu Verbindungen verwendet, welche seitenständige Reste C bilden, in denen $R^2$ in Formel II einen $\omega$-Alkylpoly-(ethylenoxid)-$\alpha$-oxyl-Rest bedeutet.

**4.** Verfahren nach einem der Ansprüche 1 bis 3, dadurch gekennzeichnet, daß man hierbei vernetzbare feste kautschukelastische Polymerisate in ihre Metall-, Ammonium- oder Hydraziniumsalze oder in ihre Salze mit mehrfachfunktionellen Aminen überführt.

**5.** Verfahren nach einem der Ansprüche 1 bis 4, dadurch gekennzeichnet, daß man hierzu Copolymerisate A verwendet, in denen die Komponente $a_3$ Vinylacetat ist.

**6.** Verfahren nach einem der Ansprüche 1 bis 4, dadurch gekennzeichnet, daß man hierzu Copolymeriste A verwendet, in denen die Komponente $a_3$ Vinyl-1-butylether ist.

**7.** Verfahren nach einem der Ansprüche 1 bis 4, dadurch gekennzeichnet, daß man hierzu Copolymerisate A verwendet, in denen die Komponente $a_3$ n-Butylacrylat, 2-Ethylhexylacrylat, Dicyclopentadienylacrylat und/oder $\omega$-Methyl-poly(ethylenoxid)-$\alpha$-yl-acrylat ist.

8. Verfahren zur Herstellung photovernetzter Druckformen, Reliefformen und Photoresists durch bildmäßiges Belichten und Auswaschen der unbelichteten Schichtanteile mittels eines Entwicklerlösungsmittels von photovernetzbaren Druckplatten, Reliefplatten und Photoresists, welche reliefbildende Schichten (RS) aufweisen, die vernetzbare feste kautschukelastische Polymerisate und Photoinitiatoren enthalten, dadurch gekennzeichnet, daß man hierbei das Produkt des Verfahrens gemäß einem der Ansprüche 1 bis 7 verwendet.

**Claims**
**Claims for the following Contracting States : CH, DE, FR, GB, IT, NL, SE**

1. A crosslinkable, solid, elastomeric polymer in the acid form or in the form of its salts, which is obtainable by polymer-analogous reaction of
   A) a copolymer of
      $a_1$) from 30 to 70 parts by weight of ethylene,
      $a_2$) from 5 to 40 parts by weight of acrylic acid and/or methacrylic acid, and
      $a_3$) from 5 to 50 parts by weight of one or more vinyl esters, vinyl ethers, acrylates, methacrylates, acrylamides and/or methacrylamides,
   with
   B) compounds by means of which side radicals of the formula I

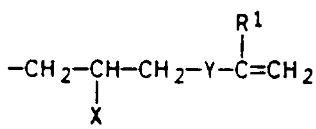

I

   where X is hydroxyl, amino or mercapto, Y is an ester, amide, ether or $C_1$-$C_{10}$-alkylene group and $R^1$ is hydrogen or methyl,
   and
   C) if required, further side radicals of the formula II

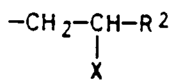

II

   where $R^2$ is a polar group, hydrogen or a further group X, are introduced into copolymer A.

2. A polymer as claimed in Claim 1, wherein copolymer A consists of
   $a_1$) from 40 to 60 parts by weight of ethylene,
   $a_2$) from 8 to 30 parts by weight of acrylic acid and/or methacrylic acid, and
   $a_3$) from 20 to 40 parts by weight of one or more vinyl esters, vinyl ethers, acrylates, methacrylates, acrylamides and/or methacrylamides.

3. A polymer as claimed in Claims 1 and 2, which contains side radicals C which have been introduced by a polymer-analogous reaction and in which $R^2$ in formula II is $\omega$-alkylpoly(ethylene oxide)-$\alpha$-oxyl.

4. A polymer as claimed in Claims 1 to 3, which is present in the form of its metal, ammonium or hydrazinium salts or as salts of polyfunctional amines.

5. A polymer as claimed in Claims 1 to 4, wherein component $a_3$ is vinyl acetate.

6. A polymer as claimed in Claims 1 to 4, wherein component $a_3$ is vinyl but-1-yl ether.

7. A polymer as claimed in Claims 1 to 4, wherein component $a_3$ is n-butyl acrylate, 2-ethylhexyl acrylate, dicyclopentadienyl acrylate and/or $\omega$-methylpoly-(ethylene oxide)-$\alpha$-yl acrylate.

**8.** The use of a polymer as claimed in any of Claims 1 to 7 for the production of photocrosslinkable printing plates, relief plates or photoresists.

**9.** The use of a polymer as claimed in any of Claims 1 to 7 for the production of photocrosslinked printing plates, relief plates or photoresists.

**10.** A photocrosslinkable printing plate, relief plate or photoresist, produced using a polymer as claimed in any of Claims 1 to 7.

**Claims for the following Contracting States : AT, ES**

**1.** A process for the preparation of a photocrosslinkable, solid, elastomeric polymer in the acid form or in the form of its salts, in which olefinically unsaturated side radicals B and, if required, further side radicals C are introduced into a copolymer A by a polymer-analogous reaction, which comprises using for this purpose

A) a copolymer of

$a_1$) from 30 to 70 parts by weight of ethylene,

$a_2$) from 5 to 40 parts by weight of acrylic acid and/or methacrylic acid, and

$a_3$) from 5 to 50 parts by weight of one or more vinyl esters, vinyl ethers, acrylates, methacrylates, acrylamides and/or methacrylamides,

and

B) compounds which form side radicals of the formula I

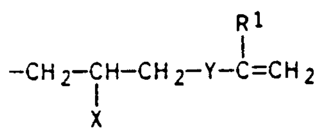

I

where X is hydroxyl, amino or mercapto, Y is an ester, amide, ether or $C_1$-$C_{10}$-alkylene group and $R^1$ is hydrogen or methyl,

and

C) if required, further compounds which form side radicals of the formula II

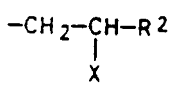

II

where $R^2$ is a polar group, hydrogen or a further group X.

**2.** A process as claimed in Claim 1, which comprises using for this purpose a copolymer A of

$a_1$) from 40 to 60 parts by weight of ethylene,

$a_2$) from 8 to 30 parts by weight of acrylic acid and/or methacrylic acid, and

$a_3$) from 20 to 40 parts by weight of one or more vinyl esters, vinyl ethers, acrylates, methacrylates, acrylamides and/or methacrylamides.

**3.** A process as claimed in Claims 1 and 2, which comprises using for this purpose compounds which form side radicals C in which $R^2$ in formula II is $\omega$-alkylpoly(ethylene oxide)-$\alpha$-oxyl.

**4.** A process as claimed in any of Claims 1 to 3, which comprises converting a photocrosslinkable, solid, elastomeric polymer into its metal, ammonium or hydrazinium salts or into its salts with polyfunctional amines.

**5.** A process as claimed in any of Claims 1 to 4, which comprises using for this purpose a copolymer A in which component $a_3$ is vinyl acetate.

**6.** A process as claimed in any of Claims 1 to 4, which comprises using for this purpose a copolymer A in

which component $a_3$ is vinyl but-1-yl ether.

**7.** A process as claimed in any of Claims 1 to 4, which comprises using for this purpose a copolymer A in which component $a_3$ is n-butyl acrylate, 2-ethylhexyl acrylate, dicyclopentadienyl acrylate and/or $\omega$-methylpoly-(ethylene oxide)-$\alpha$-yl acrylate.

**8.** A process for the production of photocrosslinked printing plates, relief plates or photoresists by imagewise exposure and washing out of the unexposed layer parts, using a developer, of photocrosslinkable printing plates, relief plates, and photoresists having relief-forming layers (RL) which contain crosslinkable, solid elastomeric polymers and photoinitiators, which comprises using the product of a process as claimed in any of Claims 1 to 7.

**Revendications**
**Revendications pour les Etats contractants suivants : CH, DE, FR, GB, IT, NL, SE**

**1.** Polymères solides réticulables élastiques à la manière des caoutchoucs, à l'état d'acide ou de sels, obtenus par réaction, analogue à une polymérisation, de :
A) un copolymère de
a1) 30 à 70 parties en poids d'éthylène
a2) 5 à 40 parties en poids d'acide acrylique et/ou méthacrylique, et
a3) 5 à 50 parties en poids d'un ou plusieurs esters vinyliques, esters acryliques, esters méthacryliques, acrylamides et/ou méthacrylamides,
avec
B) des composés au moyen desquels on introduit dans le copolymère A) des groupes latéraux de formule générale I

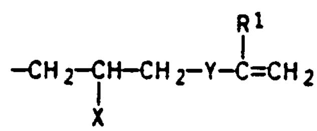
I,

dans lesquels
X représente un groupe hydroxy, amino ou mercapto,
Y représente un groupe ester, amide, éther ou alkylène en C1-C10, et
$R^1$ représente un atome d'hydrogène ou un groupe méthyle,
et
C) le cas échéant d'autres groupes latéraux de formule générale II

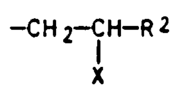
II,

dans lesquels
$R^2$ représente un groupe polaire, un atome d'hydrogène ou un autre groupe X.

**2.** Polymères selon la revendication 1, caractérisés en ce que le copolymère A) consiste en :
a1) 40 à 60 parties en poids d'éthylène,
a2) 8 à 30 parties en poids d'acide acrylique et/ou méthacrylique, et
a3) 20 à 40 parties en poids d'un ou plusieurs esters vinyliques, éthers vinyliques, esters acryliques, esters méthacryliques, acrylamides et/ou méthacrylamides.

**3.** Polymères selon les revendications 1 et 2, caractérisés en ce qu'ils contiennent, introduits par une réaction analogue à une polymérisation, des groupes latéraux C) dans lesquels $R^2$ de la formule II représente un groupe oméga-alkylpoly-(oxyde d'éthylène)-alpha-oxyde.

**4.** Polymères selon les revendications 1 à 3, caractérisés en ce qu'il sont à l'état de sels métalliques, d'ammonium ou d'hydrazinium ou à l'état de sels d'amines polyfonctionnelles.

**5.** Polymères selon les revendications 1 à 4, caractérisés en ce que le composant a3) est l'acétate de vinyle.

**6.** Polymères selon les revendications 1 à 4, caractérisés en ce que le composant a3) est l'éther vinyl-1-butylique.

**7.** Polymères selon les revendications 1 à 4, caractérisés en ce que le composant a3) est l'acrylate de n-butyle, l'acrylate de 2-éthylhexyle, l'acrylate de dicyclopentadiényle et/ou l'acrylate d'oméga-méthyl-poly-(oxyde d'éthylène)-alpha-yle.

**8.** Utilisation des polymères selon l'une des revendications 1 à 7 pour la préparation de plaques d'impression, plaques à relief et photoréserves photoréticulables.

**9.** Utilisation des polymères selon l'une des revendications 1 à 7 pour la fabrication de formes d'impression, formes à relief et photoréserves photoréticulées.

**10.** Utilisation d'impression, plaques à relief et photoréserves photoréticulables, préparées par utilisation de polymères selon l'une des revendications 1 à 7.

**Revendications pour les Etats contractants suivants : AT, ES**

**1.** Procédé de préparation de polymères solides réticulables, élastiques à la manière des caoutchoucs, à l'état d'acide ou à l'état de sels, dans lequel on introduit dans un copolymère A) des groupes latéraux à insaturation oléfinique B) et le cas échéant d'autres groupes latéraux C) par réaction analogue à une polymérisation, caractérisé en ce que l'on utilise à cet effet :

A) un copolymère de

a1) 30 à 70 parties en poids d'éthylène,

a2) 5 à 40 parties en poids d'acide acrylique et/ou méthacrylique, et

a3) 5 à 50 parties en poids d'un ou plusieurs esters vinyliques, éthers vinyliques, esters acryliques, esters méthacryliques, acrylamides et/ou méthacrylamides, et

B) des composés formant des groupes latéraux de formule générale I

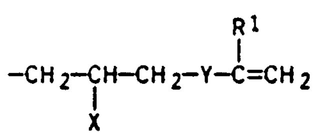

I,

dans lesquels

X représente un groupe hydroxy, amino ou mercapto,

Y représente un groupe ester, amide, éther ou alkylène en C1-C10, et

$R^1$ représente un atome d'hydrogène ou un groupe méthyle,

et

C) le cas échéant d'autres composés formant des groupes latéraux de formule générale II

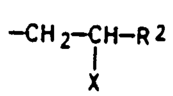

II,

dans lesquels

$R^2$ représente un groupe polaire, un atome d'hydrogène ou un autre groupe X.

**2.** Procédé selon la revendication 1, caractérisé en ce que l'on utilise un copolymère A) de
a1) 40 à 60 parties en poids d'éthylène,
a2) 8 à 30 parties en poids d'acide acrylique et/ou méthacrylique, et
a3) 20 à 40 parties en poids d'un ou plusieurs esters vinyliques, éthers vinyliques, esters acryliques, esters méthacryliques, acrylamides et/ou méthacrylamides.

**3.** Procédé selon l'une des revendications 1 et 2, caractérisé en ce que l'on utilise des composés qui forment des groupes latéraux C) dans lesquels le symbole $R^2$ de la formule II représente un groupe oméga-alkylpoly-(oxyde d'éthylène)-alpha-oxyle.

**4.** Procédé selon l'une des revendications 1 à 3, caractérisé en ce que l'on convertit des polymères solides réticulables, élastiques à la manière des caoutchoucs, en leurs sels métalliques, d'ammonium ou d'hydrazinium ou en leurs sels d'amines polyfonctionnelles.

**5.** Procédé selon l'une des revendications 1 à 4, caractérisé en ce que l'on utilise des copolymères dans lesquels le composant a3) est l'acétate de vinyle.

**6.** Procédé selon l'une des revendications 1 à 4, caractérisé en ce que l'on utilise des copolymères dans lesquels le composant a3) est l'éther vinyl-1-butylique.

**7.** Procédé selon l'une des revendications 1 à 4, caractérisé en ce que l'on utilise des copolymères A) dans lesquels le composant a3) est l'acrylate de n-butyle, l'acrylate de 2-éthylhexyle, l'acrylate de dicyclopentadiényle et/ou l'acrylate d'oméga-méthylpoly-(oxyde d'éthylène)-alpha-yle.

**8.** Procédé pour la fabrication de formes d'impression, formes en relief et photoréserves photoréticulables par exposition à la lumière avec formation d'une image et lavage des régions de la couche non éclairées à l'aide d'un solvant révélateur de plaques d'impression, plaques en relief et photoréserves photoréticulables portant des couches formant relief (RS), qui contiennent des polymères solides réticulables élastiques à la manière des caoutchoucs et des photo-inducteurs, caractérisé en ce que l'on utilise à cet effet le produit du procédé selon l'une des revendications 1 à 7.